(19) Europäisches Patentamt
European Patent Office
Office européen des brevets

(11) **EP 3 341 977 B1**

(12) **FASCICULE DE BREVET EUROPEEN**

(45) Date de publication et mention
de la délivrance du brevet:
**17.04.2019 Bulletin 2019/16**

(21) Numéro de dépôt: **16757021.7**

(22) Date de dépôt: **25.08.2016**

(51) Int Cl.:
***H01L 35/30*** *(2006.01)*

(86) Numéro de dépôt international:
**PCT/EP2016/070054**

(87) Numéro de publication internationale:
**WO 2017/032821 (02.03.2017 Gazette 2017/09)**

(54) **CONVERTISSEUR THERMOELECTRIQUE THERMIQUEMENT TRANSPARENT**

WÄRMETRANSPARENTER THERMOELEKTRISCHER WANDLER

THERMALLY TRANSPARENT THERMOELECTRIC CONVERTER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **27.08.2015 FR 1557950**

(43) Date de publication de la demande:
**04.07.2018 Bulletin 2018/27**

(73) Titulaire: **Commissariat à l'Énergie Atomique
et aux Énergies Alternatives
75015 Paris (FR)**

(72) Inventeur: **CAROFF, Tristan
38300 Bourgoin-Jallieu (FR)**

(74) Mandataire: **Cabinet Laurent & Charras
Le Contemporain
50 Chemin de la Bruyère
69574 Dardilly Cedex (FR)**

(56) Documents cités:
EP-A1- 1 970 973    EP-A1- 2 312 661
US-A1- 2005 279 104    US-A1- 2013 087 180

• CAROFF T ET AL: "Transient cooling of power electronic devices using thermoelectric coolers coupled with phase change materials", 19TH INTERNATIONAL WORKSHOP ON THERMAL INVESTIGATIONS OF ICS AND SYSTEMS (THERMINIC), IEEE, 25 septembre 2013 (2013-09-25), pages 262-267, XP032527285, DOI: 10.1109/THERMINIC.2013.6675252 ISBN: 978-1-4799-2271-0 [extrait le 2013-11-25]
• SZEKELY V ET AL: "Realization of an electronically controlled thermal resistance", MICROELECTRONICS JOURNAL, MACKINTOSH PUBLICATIONS LTD. LUTON, GB, vol. 31, no. 9-10, 1 octobre 2000 (2000-10-01), pages 811-814, XP004218844, ISSN: 0026-2692, DOI: 10.1016/S0026-2692(00)00063-X

**Description**

**DOMAINE DE L'INVENTION**

L'invention a trait au domaine des convertisseurs thermoélectrique, notamment à effet Seebeck. L'invention trouve particulièrement application dans les domaines où le convertisseur thermoélectrique est utilisé pour produire de l'électricité à partir de chaleur fatale produite par un processus industriel tout en perturbant au minimum ledit processus.

**ETAT DE LA TECHNIQUE**

Certains processus industriels, par exemple la production métallurgique (aluminium, acier, sodium, etc.), ou la production de verre, nécessitent l'apport ou produisent un flux de chaleur contraint, ou chaleur « fatale », dont une partie est perdue. Dans ce contexte, des convertisseurs thermoélectriques, constitué d'un module thermoélectrique empilé avec un dissipateur thermique (ou radiateur), ont été utilisés pour convertir au moins une partie de cette énergie auparavant gaspillée. Toutefois, l'utilisation sans précaution particulière d'un générateur thermoélectrique peut perturber le processus à la source de cette chaleur, par exemple parce qu'il ajoute une résistance thermique importante à l'endroit où il est disposé, ce qui peut par exemple induire une accumulation de chaleur non souhaitable. Pour palier ceci, il est primordiale de se doter de convertisseurs thermoélectriques qui perturbent a minima le processus dont il tire la chaleur, à savoir un convertisseur dit « thermiquement transparent ».

Afin de limiter les perturbations thermiques de certains processus, des dispositifs thermiquement transparents ont été développés et utilisés comme interface thermique, comme par exemples décrits dans le document US 2012/0153316 et CA 1150364. Le document EP 1 970 973 A1 divulgue un dispositif thermoélectrique pour une source de chaleur de haute résistance thermique. Pour l'essentiel, ces solutions consistent soit à concevoir un dispositif qui est intrinsèquement le plus transparent possible, par exemple en concevant un convertisseur ayant une résistance thermique faible, notamment en prévoyant dans celui-ci des couches particulières de matériau, soit à intégrer un circuit de régulation de température (e.g. un module Peltier), qui permet de contrôler les températures et échanges thermiques. Ces solutions ne permettent pas une conversion du flux de chaleur en électricité et peuvent nécessiter la mise en place d'un contrôle actif de régulation des températures et flux thermiques au niveau de l'interface thermique

**EXPOSE DE L'INVENTION**

Le but de la présente invention est de fournir un convertisseur thermoélectrique thermiquement transparent qui soit passif et qui soit libre dans le choix de ses matériaux et de sa structure.

A cet effet, l'invention a pour objet un convertisseur thermoélectrique comportant :

- une surface chaude ou destinée à être chauffée ;
- un générateur thermoélectrique comportant une première et une seconde plaques et un module thermoélectrique disposé entre lesdites plaques, la première plaque étant posée sur la surface destinée à être chauffée ; et
- un dissipateur thermique pour évacuer de la chaleur par convection, ledit dissipateur thermique étant posé sur la seconde plaque du générateur thermoélectrique ;

Selon l'invention, pour au moins un régime de convection prédéterminé :

$$R_{th}^{S} = R_{th}^{TE} + R_{th}^{Rad}$$

expression dans laquelle :

- $R_{th}^{S}$ est la résistance thermique de convection de la surface chaude ou destinée à être chauffée ;
- $R_{th}^{TE}$ est la résistance thermique de conduction du générateur thermoélectrique ; et
- $R_{th}^{Rad}$ est la résistance thermique de convection et/ou radiation du dissipateur thermique (ou radiateur).

En d'autres termes, plutôt que de rechercher un convertisseur thermoélectrique dont les propriétés intrinsèques, indépendantes donc de l'environnement dans lequel il est disposé, garantissent une certaine transparence, l'invention met en oeuvre une adaptation de la résistance thermique du convertisseur avec la résistance thermique de la surface sur laquelle il est destiné à être posé. Ce faisant, l'accumulation de chaleur dans le convertisseur est donc limitée. Par ailleurs, la résistance thermique du générateur dépendant de plusieurs paramètres, il est possible de régler celle-ci sans être contraint par le choix des matériaux, par exemple en réglant la résistance thermique au moyen de la structure du convertisseur.

Selon un mode de réalisation, le dissipateur thermique est destiné à fonctionner en convection naturelle, et en ce que lesdites résistances thermiques $R_{th}^{S}$ et $R_{th}^{Rad}$ sont des résistances thermiques de convection en convection naturelle, et $R_{th}^{TE}$ une résistance thermique de conduction. Notamment, la résistance thermique surfacique du générateur thermique en convection naturelle est égale à 0,1 (K/W).m$^2$.

Selon un mode de réalisation, le dissipateur thermique est destiné à fonctionner en convection forcée, et en ce que lesdites résistances thermiques $R_{th}^{S}$, $R_{th}^{Rad}$ sont des résistances thermiques de convection en convection forcée, et $R_{th}^{TE}$ une résistance thermique de conduction. Notamment, la résistance thermique surfacique en convection forcée du générateur thermoélectrique est égale à 0,01 (K/W).m$^2$.

Selon un mode de réalisation, le module thermoélectrique est un module thermoélectrique à effet Seebeck.

Selon un mode de réalisation, les première et seconde plaques du générateur thermoélectrique sont de dimension égales et centrées l'une sur l'autre, et en ce que le dissipateur thermique recouvre sensiblement toute la seconde plaque du générateur thermoélectrique.

## BREVE DESCRIPTION DES FIGURES

L'invention sera mieux comprise à la lecture de la description qui va suivre, donnée uniquement à titre d'exemple, et réalisée en relation avec les dessins annexés dans lesquels :

- les figures 1 et 2 sont des vues schématique respectivement en perspective et de côté d'un convertisseur thermoélectrique thermiquement transparent; et
- les figures 3a et 3b sont des vues schématique d'exemples de convertisseurs thermoélectriques utilisés en tant que capteur de flux thermique.

## DESCRIPTION DETAILLEE DE L'INVENTION

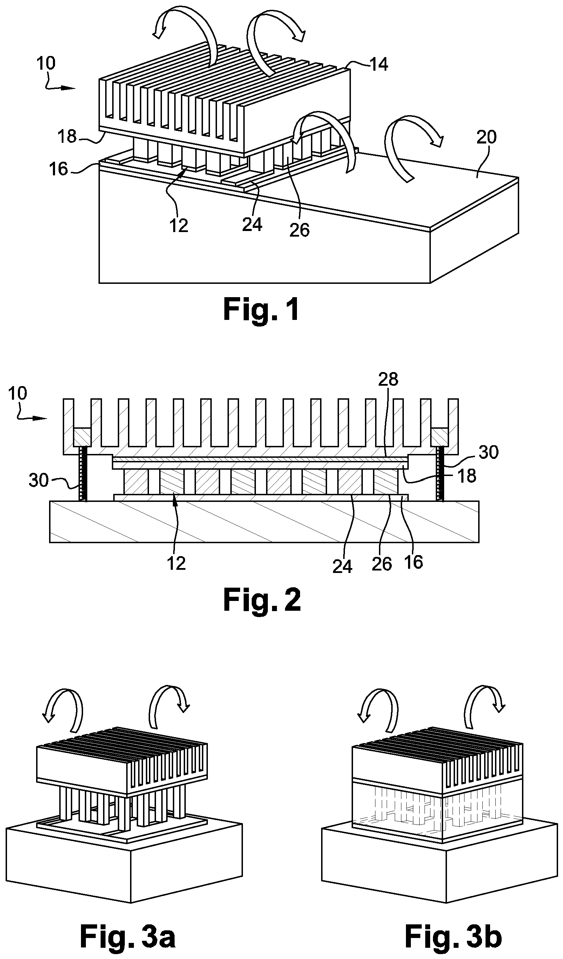

En se référant aux figures 1 et 2, un convertisseur thermoélectrique **10** comprend un générateur thermoélectrique **12** empilé avec un dissipateur thermique **14.**

Le générateur thermoélectrique **12** comporte :

- une première plaque **16** et une seconde plaque **18,** par exemple identiques, centrées l'une sur l'autre et formant les sources chaude et froide du générateur **12.** La première plaque **16** est posée sur une surface chauffée **20,** par exemple d'un dispositif de processus industriel, de la peau, etc..., le convertisseur **12** ayant pour objectif de convertir au moins en partie la chaleur en électricité ; et
- un module thermoélectrique à effet Seebeck **22,** agencé entre les deux plaques **16** et **18.** Le module **22** comporte d'une manière en soi connue des couples d'éléments conducteurs ou semi-conducteurs **24, 26** ayant des coefficients Seebeck différents et connectés électriquement en série, **par** exemple au moyens de bandes conductrices **28,** les couples étant également connectés électriquement en série. Le module **22** produit une tension entre deux bornes (non représentées) en fonction du gradient de température existant entre les deux plaques **16** et **18.** Les éléments **24, 26** du module **22** sont par exemple des barreaux de dimensions identiques, notamment à section carrée, et réalisés à base du même matériau (e.g. respectivement en siliciure dopé P et en siliciure dopé N), et sont régulièrement répartis entre les deux plaques **16** et **18.**

Le dissipateur thermique **14** est posé sur la seconde plaque **18** du générateur **12** de manière à évacuer la chaleur traversant ce dernier, et ainsi à augmenter le gradient de température entre les deux plaques **16, 18.** Le dissipateur thermique, qui comporte par exemple une embase ou une plaque de laquelle des ailettes sont en saillie, présente une surface d'échange thermique A' plus importante que la surface A de son embase. L'embase peut être de dimension sensiblement égale à celle de la seconde plaque **18** du générateur **12** (figure 1) ou de dimension supérieure (figure 2). Le dissipateur thermique **14** est notamment destiné à être au contact d'un fluide, par exemple de l'air, dont la température est inférieure à celle de la surface chauffée **20.**

Afin de limiter les effets parasites des résistances thermiques aux interfaces, les générateur thermoélectrique **12** et le dissipateur thermique **14** sont préférentiellement connectés l'un à l'autre à l'aide d'une couche **28** de matériau d'interfaces thermiques (« TIM »), notamment de type polymère thermiquement conducteur, de graisse thermique ou de feuille de graphite souple. Afin de garantir un contact thermique optimal, le générateur et le dissipateur thermique sont en outre bridés mécaniquement, par exemple au moyen de vis et/ou ressorts **30,** ou à défaut collés l'un à l'autre par une colle thermiquement conductrice.

Les éléments venant d'être décrits sont classiques et ne seront pas décrits plus en détail par la suite. Ils peuvent prendre n'importe quelle forme, dimension, agencement et composition, dans les limites décrites ci-après.

Selon l'invention :

$$R_{th}^S = R_{th}^{TE} + R_{th}^{Rad} \tag{1}$$

où $R_{th}^S$ est la résistance thermique de convection au niveau de la surface chauffée **20** sur laquelle est posée le générateur **12** (i.e. la résistance thermique s'opposant au flux de chaleur entre la source de chaleur et la surface chauffée **20**), $R_{th}^{TE}$ est la résistance thermique de conduction du générateur thermoélectrique **12,** et $R_{th}^{Rad}$ est la résistance thermique de convection du dissipateur thermique **14** (i.e la résistance thermique s'opposant au flux de chaleur entre le dissipateur thermique et l'extérieur).

La relation (1) est au moins valable pour le régime de convection dans lequel le convertisseur est destiné à fonctionner, par exemple en convection naturelle ou en convection forcée.

Comme cela est connu en soi, la résistance thermique de convection en surface d'un élément exprime la résistance thermique au passage d'un flux de chaleur d'origine convective ; et la résistance thermique de conduction dans un élément exprime la résistance thermique au passage d'un flux de chaleur.

Notamment, la résistance $R_{th}^S$ de la surface **20** nue, c'est-à-dire sans le convertisseur 12, s'exprime au premier ordre selon la relation :

$$R_{th}^S = \frac{1}{h_{th}^S \times A_{th}^S} \tag{2}$$

où $h_{th}^S$ est le coefficient d'échange thermique de convection de la surface **20**, et $A_{th}^S$ est la surface d'échange thermique de la surface considérée, et donc égale à l'aire de la première plaque **14** du générateur **12.** Le coefficient d'échange thermique $h_{th}^S$ est par exemple défini par le régime de convection, et appartient aux gammes décrites au tableau ci-dessous :

| Type d'échanges convectifs avec l'extérieur | Coefficient d'échange $h_{th}^S$ (W.M$^{-2}$.K$^{-1}$) |
|---|---|
| Convection libre (air) | 5 - 25 |
| Convection forcée (air) | 10 - 500 |
| Convection libre (eau) | 100 -900 |
| Convection forcée (eau) | 100 - 15000 |

De même, la résistance $R_{th}^{Rad}$ du dissipateur thermique **14** s'exprime au premier ordre selon la relation :

$$R_{th}^{Rad} = \frac{1}{h_{th}^{Rad} \times A_{th}^{Rad}} \tag{3}$$

où $h_{th}^{Rad}$ est le coefficient d'échange thermique de convection en surface du dissipateur thermique **14,** et $A_{th}^{Rad}$ est la surface d'échange thermique du dissipateur thermique **14.**

De même, la résistance $R_{th}^{TE}$ du générateur thermoélectrique **12** s'exprime au premier ordre selon la relation :

$$R_{th}^{TE} = \frac{h_{TE}}{\lambda \times N \times L_{TE}^2} \qquad (4)$$

où $h_{TE}$ et $L_{TE}$ sont respectivement la hauteur et la largeur des éléments **24, 26**, $\lambda$ est la conductivité thermique du matériau constitutif des éléments **24, 26**, et $N$ est le nombre de couples d'éléments **24, 26**.

On note ainsi que le concepteur du convertisseur de l'invention dispose des paramètres du dissipateur thermique **14** pour régler la différence de $R_{th}^S - R_{th}^{Rad}$ et du nombre, de la géométrie, et du matériau des éléments **24, 26** pour régler la résistance $R_{th}^{TE}$ sur la valeur $R_{th}^S - R_{th}^{Rad}$.

Notamment, pour un dissipateur thermique conçu de telle sorte que $h_{th}^{Rad} = h_{th}^S$ et $A_{th}^{Rad} = p \times A_{th}^S$, où p est supérieur à 1, le générateur **12** vérifie donc :

$$R_{th}^{TE} = \frac{1}{h_{th}^S \times A_{th}^S} \times \left(1 - \frac{1}{p}\right) \qquad (5)$$

Ainsi, plus le dissipateur thermique est efficace pour évacuer la chaleur par convection, par exemple en choisissant un dissipateur thermique tel que $p \geq 5$, et de préférence $p \geq 10$, la résistance thermique de conduction du générateur **12** s'approche de la résistance thermique en convection de la surface chauffée **20.**

Par exemple, pour p = 5, et $h_{th}^S$ compris entre 5 et 10 W/m2/K en convection naturelle, la résistance thermique $R_{th}^{TE}$ (somme des résistances thermiques de conduction et convection) du générateur est égale ou proche de 0.1 (K/W).m$^2$, et pour $h_{th}^S = 100$ W/m2/K en convection forcée, la résistance thermique $R_{th}^{TE}$ (somme des résistances thermiques de conduction et convection) est égale à 0,01 (K/W).m$^2$. Ainsi, pour une surface développée d'échange thermique côté dissipateur thermique $A_{th}^{Rad} \geq 5 \times A_{th}^S$, le générateur **12** est réglé sur une résistance thermique de l'ordre de $\frac{1}{h_{th}^S} A_{th}^S$ (KW)/.m$^2$, avec $h_{th}^S$ défini par le mode de convection.

Il a été décrit l'utilisation du convertisseur thermoélectrique en tant que générateur d'électricité. Le convertisseur thermiquement transparent selon l'invention peut également être utilisé comme capteur de flux thermique transparent (mesure de flux échangé par convection ou radiation). L'invention associée à la mesure de flux thermique permet de réaliser des mesures de flux pour le bâtiment, les procédés industriels (métallurgie, verre, pétrochimie, ..) sans influencer thermiquement la zone de mesure, et ainsi donner une mesure plus pertinente du flux thermique généré lors du procédé ou du flux échangé avec l'environnement.

Un exemple de capteur convectif de 20 mm * 20 mm thermiquement transparent pour le bâtiment est composé d'un module thermoélectrique de 16 thermo-éléments en $Bi_2Te_3$ de 1*1 mm$^2$ et 5.5 mm de haut (conductivité thermique de 1,4 W/m/K), ayant une résistance thermique de l'ordre de 250 K/W, monté en série avec un dissipateur thermique de 20 *20 mm$^2$ de 25 K/W, tel qu'illustré à la figure 3a. La taille des éléments thermoélectriques du capteur étant assez élevée (5.5 mm), le module thermoélectrique est dans une variante privilégiée, scellé avec un isolant thermique type aérogel pour limiter les pertes thermiques par convection au sein du module, tel qu'illustré à la figure 3b.

Dans un mode de réalisation, en environnement très chaud, un intercalaire thermique isolant entre la surface d'intérêt et les modules thermoélectriques est utilisé pour limiter la température au niveau du module thermoélectrique, par exemple une plaque de MACOR®, de mica, de laine de roche, d'alumine poreuse, etc., et ainsi éviter sa détérioration.

Dans cette configuration, afin de conserver la transparence thermique, la résistance $R_{th}^S$ est remplacé par $R_{th}^S - R_{th}^{int}$, où $R_{th}^{int}$ est la résistance thermique de conduction de l'intercalaire. En reprenant, les valeurs numériques précédentes, la résistance $R_{th}^{TE}$ du générateur 12 est alors réglée sur $\frac{1}{h_{th}^S} . A_{th}^S - R_{th}^{int}$.

L'invention trouve ainsi application dans :

- les montres thermoélectriques ou tout autre dispositif portatif thermoélectrique autonome (podomètre TE, GPS TE, ...), car il évite la sensation de froid sur la peau ;
- la récupération d'énergie sur un procédé industriel fortement lié à la thermique (cuve d'aluminisation, industrie de l'acier, du verre,...);

- les capteurs transparents de flux thermique convectif.

**Revendications**

1. Convertisseur thermoélectrique comportant :

   - une surface (20) chaude ou destinée à être chauffée ;
   - un générateur thermoélectrique (12) comportant une première et une seconde plaques (16, 18) et un module thermoélectrique (22) disposé entre lesdites plaques (16, 18), la première plaque (16) étant posée sur la surface (20) destiné à être chauffée ; et
   - un dissipateur thermique (14) pour évacuer de la chaleur par convection, ledit dissipateur thermique étant posé sur la seconde plaque (18) du générateur thermoélectrique (12) ;

   **caractérisé en ce que** pour au moins un régime de convection prédéterminé, la relation suivante est vérifiée :

   $$R_{th}^{S} = R_{th}^{TE} + R_{th}^{Rad}$$

   expression dans laquelle :
   - $R_{th}^{S}$ est la résistance thermique de convection de la surface destinée à être chauffée ;
   - $R_{th}^{TE}$ est la résistance thermique de conduction du générateur thermoélectrique ;
   - et $R_{th}^{Rad}$ est la résistance thermique de convection et/ou radiation du dissipateur thermique.

2. Convertisseur thermoélectrique selon la revendication 1, **caractérisé en ce que** le dissipateur thermique est destiné à fonctionner en convection naturelle, et **en ce que** lesdites résistances thermiques $R_{th}^{S}$ et $R_{th}^{Rad}$ sont des résistances thermiques de convection en convection naturelle, et $R_{th}^{TE}$ une résistance thermique de conduction

3. Convertisseur thermoélectrique selon la revendication 2, **caractérisé en ce que** la résistance thermique surfacique du générateur thermique en convection naturelle est égale à 0,1 (K/W).m$^2$ (somme des résistances thermiques de conduction et convection)

4. Convertisseur thermoélectrique selon la revendication 1, **caractérisé en ce que** le dissipateur thermique est destiné à fonctionner en convection forcée, et **en ce que** lesdites résistances thermiques $R_{th}^{S}$, $R_{th}^{Rad}$ sont des résistances thermiques de convection en convection forcée, et $R_{th}^{TE}$ une résistance thermique de conduction.

5. Convertisseur thermoélectrique selon la revendication 4, **caractérisé en ce que** la résistance thermique surfacique en convection forcée du générateur thermoélectrique est égale à 0,01 (K/W).m$^2$ (somme des résistances thermiques de conduction et convection)

6. Convertisseur thermoélectrique selon l'une quelconque des revendications précédentes, **caractérisé en ce que** le module thermoélectrique est un module thermoélectrique à effet Seebeck.

7. Convertisseur thermoélectrique selon l'une quelconque des revendications précédentes, **caractérisé en ce que** les première et seconde plaques du générateur thermoélectrique sont de dimension égales et centrées l'une sur l'autre, et **en ce que** le dissipateur thermique recouvre sensiblement toute la seconde plaque du générateur thermoélectrique.

**Patentansprüche**

1. Thermoelektrischer Wandler, der umfasst:

- eine Oberfläche (20), die warm ist oder erwärmt werden soll;
- einen thermoelektrischen Generator (12) mit ersten und zweiten Platten (16, 18) und ein thermoelektrisches Modul (22), das zwischen diesen Platten (16, 18) angeordnet ist, die erste Platte (16) ist auf der zu erwärmenden Oberfläche (20) positioniert, und
- einen Kühlkörper (14) zum Abführen der Wärme durch Konvektion, wobei dieser Kühlkörper auf der zweiten Platte (18) des thermoelektrischen Generators (12) positioniert ist;

*dadurch gekennzeichnet, dass* für mindestens eine vorher festgelegte Konvektionssteuerung die folgende Gleichung überprüft wird:
eine Formel in der:

$$R^{s}_{th} = R^{TE}_{th} + R^{Rad}_{th}$$

- $R^{s}_{th}$ der Konvektions- Wärmewiderstand der zu erwärmenden Fläche ist;
- $R^{TE}_{th}$ der Konvektions- Wärmewiderstand des thermoelektrischen Generators ist;
- und $R^{Rad}_{th}$ der Konvektions- und/ oder Wärmewiderstand des Kühlkörpers ist.

2. Thermoelektrischer Wandler gemäß Anspruch 1, *dadurch gekennzeichnet, dass* der Kühlkörper mit natürlicher Konvektion funktionieren soll und dass diese Wärmewiderstände $R^{s}_{th}$ und $R^{Rad}_{th}$ Konvektions- Wärmewiderstände bei natürlicher Konvektion sind und $R^{TE}_{th}$ ein Wärmeleitwiderstand ist.

3. Thermoelektrischer Wandler gemäß Anspruch 2, *dadurch gekennzeichnet, dass* der Oberflächen- Wärmewiderstand des thermischen Generators bei natürlicher Konvektion gleich 0,1 (K/W).m$^2$ (Summe des Wärmeleitwiderstandes und des Konvektions- Wärmewiderstandes) ist.

4. Thermoelektrischer Wandler gemäß Anspruch 1, *dadurch gekennzeichnet, dass* der Kühlkörper mit erzwungener Konvektion arbeitet und dass es sich bei diesen Wärmewiderständen $R^{s}_{th}$, $R^{Rad}_{th}$ um Wärmewiderstände mit erzwungener Konvektion handelt und bei $R^{TE}_{th}$ um einen Wärmeleitwiderstand.

5. Thermoelektrischer Wandler gemäß Anspruch 4, *dadurch gekennzeichnet, dass* der Oberflächen- Wärmewiderstand des thermischen Generators bei natürlicher Konvektion gleich 0,01 (K/W).m$^2$ (Summe des Wärmeleitwiderstandes und des Konvektions- Wärmewiderstandes) ist.

6. Thermoelektrischer Wandler gemäß irgendeinem der vorstehenden Ansprüche, *dadurch gekennzeichnet, dass* es sich bei dem thermoelektrischen Modul um ein thermoelektrisches Modul mit Seebeck- Effekt handelt.

7. Thermoelektrischer Wandler gemäß irgendeinem der vorstehenden Ansprüche *dadurch gekennzeichnet, dass* die erste und die zweite Platte des thermoelektrischen Generators dieselben Maße haben und aufeinander zentriert sind und dass der Kühlkörper im Wesentlichen die gesamte zweite Platte des thermoelektrischen Generators bedeckt.

**Claims**

1. Thermoelectric converter including:

- A hot (20) surface or that is designed to be heated;
- A thermoelectric generator (12) comprising a first and a second plate (16, 18) and a thermoelectric module (22) arranged between the said plates (16, 18) with the first plate (16) placed on the surface (20) to be heated; and
- A thermoelectric dissipator (14) for evacuating the heat by convection with this thermal dissipator placed on a second plate (18) of the thermoelectric generator (12);

*characterized* **in that** for at least one predetermined convection situation, the following relation is verified:

$$R^{S}_{th} = R^{TE}_{th} + R^{Rad}_{th}$$

in which expression:

- $R_{th}^S$ is the convection thermal resistance of the surface to be heated;

- $R_{th}^{TE}$ is the thermal conduction resistance of the thermoelectric generator;

- and $R_{th}^{Rad}$ is the thermal convection and/or radiation resistance of the thermal dissipator.

2. A thermoelectric converter according to claim 1 *characterized* **in that** the thermal dissipator is designed to operate by natural convection and **in that** the said thermal resistances $R_{th}^S$ and $R_{th}^{Rad}$ are the convection thermal resistances obtained by natural convection and $R_{th}^{TE}$ is a thermal conduction resistance.

3. A thermoelectric converter according to claim 2, *characterized* **in that** the thermal surface resistance of the thermal generator during natural convection is 0.1 (K/W).m2 (sum of the conduction and convection thermal resistances)

4. A ther thermoelectric mal converter according to claim 1 *characterized* **in that** the thermal dissipator is designed to operate by forced convection and **in that** the said thermal resistances $R_{th}^S$ and $R_{th}^{Rad}$ are the convection thermal resistances obtained by forced convection and $R_{th}^{TE}$ is a thermal conduction resistance.

5. A thermoelectric converter according to claim 4, **characterized in that** the thermal surface resistance of the thermal generator during forced convection is 0.01 (K/W).m2 (sum of the conduction and convection thermal resistances).

6. A thermoelectric converter according to one of the previous claims *characterized* **in that** the thermoelectric module is a Seebeck effect thermoelectric module.

7. A thermoelectric converter according to one of the previous claims *characterized* **in that** the first and second plates of the thermoelectric generator are of equal sizes and are centered on one another and **in that** the thermal dissipator covers approximately the entire surface of the second plate of the thermoelectric generator.

**Fig. 1**

**Fig. 2**

**Fig. 3a**

**Fig. 3b**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120153316 A
- CA 1150364
- EP 1970973 A1